Europäisches Patentamt

European Patent Office

Office européen des brevets

(11) Publication number: **0 115 098**
**B1**

# (12) EUROPEAN PATENT SPECIFICATION

(45) Date of publication of patent specification: **18.03.87**

(21) Application number: **83201786.7**

(22) Date of filing: **15.12.83**

(51) Int. Cl.⁴: **H 01 L 29/78,** H 01 L 29/06,
H 01 L 29/10

(54) Lateral DMOS transistor device having an injector region.

(30) Priority: **27.12.82 US 453374**

(43) Date of publication of application:
**08.08.84 Bulletin 84/32**

(45) Publication of the grant of the patent:
**18.03.87 Bulletin 87/12**

(84) Designated Contracting States:
**DE FR GB NL**

(56) References cited:
**DE-A-3 103 444**
**FR-A-2 458 907**
**US-A-4 007 478**
**US-A-4 300 150**

**IEEE TRANSACTIONS ON ELECTRON
DEVICES, vol. ED-23, no. 1, January 1976,
pages 1-4, New York, USA M.J. DECLERCQ et
al.: "Avalanche breakdown in high-voltage
D-MOS devices"**

(73) Proprietor: **N.V. Philips' Gloeilampenfabrieken
Groenewoudseweg 1
NL-5621 BA Eindhoven (NL)**

(72) Inventor: **Singer, Barry Mana**
**c/o INT. OCTROOIBUREAU B.V. Prof. Holstlaan 6
NL-5656 AA Eindhoven (NL)**
Inventor: **Colak, Sel**
**c/o INT. OCTROOIBUREAU B.V. Prof. Holstlaan 6
NL-5656 AA Eindhoven (NL)**
Inventor: **Stupp, Edward Henry**
**c/o INT. OCTROOIBUREAU B.V. Prof. Holstlaan 6
NL-5656 AA Eindhoven (NL)**

(74) Representative: **Voorrips, Hugo Carel et al
INTERNATIONAAL OCTROOIBUREAU B.V. Prof.
Holstlaan 6
NL-5656 AA Eindhoven (NL)**

Courier Press, Leamington Spa, England.

## Description

Background of the invention

The invention is in the field of metal-oxide semiconductor (MOS) field-effect transistor devices, and relates specifically to lateral DMOS field-effect transistors.

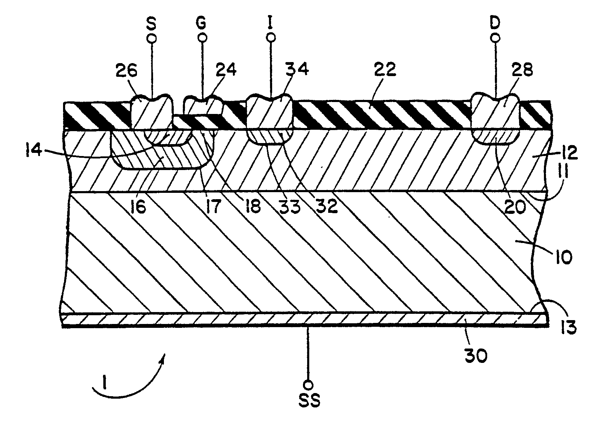

Such transistors are often referred to as double-diffused MOS-transistors although one or more zones may be made entirely or partly by ion implantation, and their gate electrodes may consist of conductive layers other than metals, for instance of polycrystalline silicon. Likewise, the insulating material between the gate electrode and the semiconductor surface may be another insulator than an oxide, for instance silicon nitride. A typical high-voltage lateral DMOS transistor is shown in Fig. 1 of US—A—4300150. This device includes a semiconductor substrate of a first conductivity type (p-type), an epitaxial surface layer of a second conductivity type (n-type) on a major surface of the substrate, a surface-adjoining channel region of the first conductivity type in the epitaxial layer, a surface-adjoining source region of the second conductivity type in the channel region, and a surface-adjoining drain region of the second conductivity type in the epitaxial layer and spaced apart from the channel region. An insulating layer is provided on the epitaxial surface layer and covers at least that portion of the channel region located between the source and drain. A gate electrode is provided on the insulating layer, over the portion of the channel region located between the source and drain and is electrically isolated from the epitaxial surface layer, while source and drain electrodes are connected respectively to the source and drain regions of the transistor. Such prior art high-voltage DMOS transistors typically have a relatively thick epitaxial layer, of the order of about 25—30 micrometers for a breakdown voltage of about 250V.

It has been found that the breakdown characteristics of high-voltage semiconductor devices can be improved by using the REduced SURface Field (or RESURF) technique, as described in "High Voltage Thin Layer Devices (RESURF Devices)", "International Electronic Devices Meeting Technical Digest", December 1979, pages 238—241, by Appels et al, and US—A—4292642. Essentially, the improved breakdown characteristics of RESURF devices are achieved by employing thinner but more highly doped epitaxial layers to reduce surface fields. Additionally, surface regions of the first conductivity type being located between the channel region and the drain region and having no direct external connections have been used to redistribute surface fields in MOS devices, as shown, for example, in US—A—4300150 and JP—A—5645074.

In US—A—4007478, a DMOS transistor with a buried layer of high impurity concentration beneath the channel region is described that is of the same conductivity type as the channel region and can be connected to an electrode on the first major surface in order to apply ground potential to the channel region and to reduce the spreading resistance of the channel region.

A vertical DMOS transistor with an injector region in the current-carrying region in order to decrease the on-resistance of the device is disclosed in DE—A1—3103444. There is no indication, however, as to how such an injector region could be located in a lateral DMOS transistor.

The RESURF technique was applied to lateral DMOS transistors, as reported in "Lateral DMOS Power Transistor Design", "IEEE Electron Device Letters", Vol. EDL-1, pages 51—53, April 1980, by Colak et al, and the result was a substantial improvement in device characteristics. In high-voltage DMOS devices, there is normally a trade-off between breakdown voltage and on-resistance, with the goal being to increase the breakdown voltage level while maintaining a relativley low on-resistance. Using the prior art RESURF technique, and for reference assuming a constant breakdown voltage, an improvement (e.g. decrease) in on-resistance by a factor of about 3 may be obtained in a device occupying the same area as a conventional (thick epitaxial layer) DMOS device. Nevertheless, a further improvement in the on-resistance characteristics of such devices would be extremely desirable, particularly for high-voltage power devices where on-resistance is an important parameter. Ideally, such an improvement in on-resistance should be obtained without degrading the breakdown voltage characteristics of the devices.

Summary of the Invention

It is therefore an object of the present invention to provide a lateral DMOS transistor which features improved on-resistance characteristics.

It is a further object of the invention to provide a lateral DMOS transistor with improved on-resistance characteristics without degrading the breakdown voltage characteristics of the device.

In accordance with the invention, these objectives are achieved by a lateral DMOS transistor of the type described above which is characterized in that a surface-adjoining injector region of the first conductivity type is provided in the epitaxial surface layer of the second conductivity type and forms a p-n junction therewith. This injector region is located between the channel region and the drain region, and is closer to the channel region than to the drain region.

An electrical connection is provided to the injector region by an injector electrode so that an external voltage can be applied directly to the injector region. In a preferred embodiment of the invention, the injector region is located adjacent to, but not in contact with, the channel region.

This injector region serves to inject minority carriers (holes) into the drift region of the device when the transistor is in the "on" state, thus resulting in more electrons being emitted from the source to maintain charge neutrality. This in turn will result in a substantial reduction in on-resistance without degrading the breakdown voltage characteristics of the device.

## Brief description of the drawing

The Figure is a cross-sectional view of a lateral DMOS transistor in accordance with the invention.

## Description of the preferred embodiment

The single Figure of the drawing shows a DMOS transistor suitable for high-voltage applications. It should be noted that the Figure is not drawn to scale, and in particular the vertical dimensions are exaggerated for improved clarity. Additionally, semiconductor regions of the same conductivity type are shown hatched in the same direction.

In the Figure, a lateral DMOS transistor 1 has a semiconductor substrate 10 of a first conductivity type, here p-type, with an epitaxial surface layer 12 of a second conductivity type opposite to that of the first, here n-type, on a first major surface 11 of the substrate. A surface-adjoining channel region 16 of the first conductivity type is provided in the epitaxial layer and forms a p-n junction 17 therewith. A surface-adjoining source region 14 of the second conductivity type is provided in the channel region 16, and a surface-adjoining drain region 20, also of the second conductivity type, is provided in the epitaxial layer 12 at a location which is spaced apart from the channel region 16. The channel region 16 has a surface-adjacent portion 18 located between the source and drain regions which forms the channel of the device. An insulating layer 22 is provided on the epitaxial surface layer 12 and covers at least that portion of the channel region 16 located between the source and drain regions of the transistor. While insulating layer 22 is shown as a stepped layer and is of silicon oxide, other configurations and insulating materials can be used without departing from the scope of the invention. A gate electrode 24 (terminal G) is provided on the insulating layer 22 over the channel 18, and source (26) and drain (28) electrodes (terminals S and D, respectively) provide electrical connections to the source and drain regions of the transistor. A substrate electrode 30 (terminal SS) provides an electrical connection to the second major surface 13 of the substrate on its lower side.

Devices of this general type (as so far described) are well known in the art, and hence will not be described in further detail. As noted above, the epitaxial surface layer 12 in such devices is typically a relatively thick layer, having a thickness of the order of about 25 to 30 micrometers for breakdown voltages of about 250 Volts. Such relatively thick epitaxial layers tend to make these devices subject to reverse avalanche breakdown of the p-n junction 17 in the curved area of the junction beneath the gate electrode 24 due to field crowding in this area. This characteristic is particularly undesirable in high-voltage applications because it limits the maximum operating voltage of the transistor.

The Reduced Surface Field (RESURF) technique, as applied to lateral DMOS transistors in the previously-mentioned Colak et al paper, serves to partially overcome this problem. By substantially reducing the epitaxial layer thickness, down to about 3 to 15 micrometers, while at the same time increasing the doping level in the epitaxial layer to maintain an acceptable on-resistance value, a substantial improvement in high-voltage breakdown characteristics can be obtained. Thus, the Figure, as so far described, may also represent a RESURF DMOS transistor, assuming that the appropriate thickness and resistivity values for the epitaxial layer 12 are selected. In accordance with the RESURF technique, the product of doping concentration and epitaxial layer thickness ($N_{epi} \times d_{epi}$) should typically be approximately $10^{12}$ atoms/cm². Using this technique, on-resistance can be reduced by a factor of about 3 for a device occupying the same area as a conventional device, while maintaining the same breakdown voltage. Nevertheless, a further reduction in on-resistance would be extremely desirable, particularly for devices intended for high-power applications.

The present invention is based upon the discovery that by providing a surface-adjoining injection region in the epitaxial surface layer between the channel region and the drain region of the device, a substantial further reduction in on-resistance can be obtained without degrading breakdown voltage characteristics. While the invention may be applied to conventional DMOS transistors, optimum performance is obtained by providing the injection region of the invention in devices in which the epitaxial layer is selected in accordance with the RESURF technique, as described above.

In accordance with the invention, lateral DMOS transistor 1 shown in the Figure is provided with a surface-adjoining injector region 32 of the first conductivity type (p-type) in the n-type epitaxial surface layer 12, thus forming p-n junction 33 between the injector region 32 and the epitaxial layer 12. Injector region 32 is located between the channel region 16 and the drain region 20, and, as shown in the Figure, is closer to the channel region than to the drain region. In a preferred embodiment of the device, injector region 32 is located adjacent to, but not in contact with, channel region 16 for optimum operation.

In a typical RESURF device, in which the epitaxial layer 12 may have a thickness of about 10 micrometers and a doping level of about $1.0 \times 10^{15}$ atoms/cm³, and the substrate 10 has a doping level of about $4.0 \times 10^{14}$ atoms/cm³, the injector region 32 can have a thickness of about 1.0 micrometer and a surface doping level of about $10^{19}$ atoms/cm³. In this example, the substrate and injector region are of p-type material, while the epitaxial layer is n-type. The method of formation of the injector region is not critical, so that conventional implantation diffusion techniques may be used in its fabrication as desired.

The device construction is completed by an injector electrode 34 which is electrically connected to injector region 32 at its upper surface. The injector electrode 34 contacts the injector 32 through insulating layer 22 to provide a direct injector electrode connection (terminal I) at the upper surface of the device.

A lateral DMOS transistor in accordance with the invention, such as that shown in the Figure, will be operated in "on" state with a small positive voltage (in the range of about 1 to 3 volts) applied directly to the injector region by injection electrode 34. With the source electrode 26 and substrate electrode 30 connected to ground, and a high voltage applied to the drain electrode 28, the transistor is turned "on" by placing a suitable positive voltage on the gate electrode 24. Majority carriers (electrons) will then flow from the source region 14 through the channel 18 and the drift region (that part of the epitaxial layer 12 between the channel and drain) toward the drain region 20. When the device is "on", the voltage in the epitaxial layer 12 in the vicinity of injector region 32 is typically less than a volt, so that the p-n junction 33 will be forward biased, and minority carriers (holes) will be injected from the injector region 32 into the drift region. This will cause more electrons to enter the drift region from the source region 14 in order to maintain charge neutrality in the drift region, thus resulting in a significant reduction in on-resistance.

In the "off" state, with substantially no conduction between the source and drain, the voltage in the region of the epitaxial layer 12 in the vicinity of the injector region 32 will rise to about 10 volts, thus reverse-biasing the p-n junction 33 and automatically cutting off the injection of minority carriers from the injection region into the drift region. When the device is switched "off", the holes present in the drift region due to injection in the "on" state will diffuse to and be collected by the grounded substrate, which acts as a hole sink. Turn-off speed is enhanced by both the relative thinness of the epitaxial layer 12 (due to the use of the RESURF technique) and the large interfacial area between the epitaxial layer 12 and the substrate 10.

With respect to the injector bias voltage, two modes of operation are possible. If a relatively low voltage (for example 1.5 volts) is applied to the injector region, this voltage can be maintained constant in both the "on" and "off" states. On the other hand, if a higher voltage is applied to the injector region (for example 3.0 volts) this voltage must either be reduced or removed in the "off" state. While this second mode of operation requires somewhat more complexity, it results in a greater reduction in on-resistance.

Computer analysis and preliminary testing indicate that use of an injector region in accordance with the present invention can decrease the on-resistance of a lateral DMOS transistor by a factor of about 10 times, and that this substantial improvement can be obtained with substantially no degradation of the breakdown voltage characteristics of the device. While it is believed that devices in accordance with the present invention will have somewhat slower switching speeds than conventional lateral DMOS devices, it is predicted that switching times will be faster than those for conventional bipolar power transistors and more than adequate for most applications.

Thus, by providing a lateral DMOS transistor with an injector region between the channel region and the drain region, the present invention serves to substantially reduce the on-resistance characteristics of the device without impairing its high-voltage breakdown characteristics.

## Claims

1. A lateral DMOS transistor having a semiconductor substrate of a first conductivity type, an epitaxial surface layer of a second conductivity type opposite to that of the first conductivity type on a first major surface of said substrate, a surface-adjoining channel region of said first conductivity type in said epitaxial layer and forming a p-n junction therewith, a surface-adjoining source region of said second conductivity type in said channel region, a surface-adjoining drain region of said second conductivity type in said epitaxial layer and spaced apart from said channel region, an insulating layer on said epitaxial layer and covering at least that portion of said channel region located between said source region and said drain region, a gate electrode on said insulating layer, over said portion of the channel region and electrically isolated from said epitaxial layer, source and drain electrodes connected respectively to the source and drain regions of said transistor, and a substrate electrode on a second major surface of said substrate opposite to the first major surface, characterized in that a surface-adjoining injector region of said first conductivity type is provided in said epitaxial surface layer of the second conductivity type and forms a p-n junction therewith, said injector region being located between said channel region and said drain region and closer to said channel region than to said drain region, and that an injector electrode is electrically connected to said injector region so that an external voltage can be applied directly to said injector region.

2. A lateral DMOS transistor as in claim 1, wherein the doping concentration N and thickness d of said epitaxial surface layer are selected in accordance with the REduced SURface Field (RESURF) technique so that approximately $N \times d = 10^{12}$ atoms/cm$^2$.

3. A lateral DMOS transistor as in claim 1, wherein said surface-adjoining injector region is located adjacent to, but not in contact with, said channel region.

4. A lateral DMOS transistor as in claim 1, wherein said injector region has a thickness of about one micrometer and a surface doping level of about $10^{19}$ atoms/cm$^3$.

## Patentansprüche

1. Lateraler DMOS-Transistor mit einem Halbleitersubstrat eines ersten Leitungstyps, einer Epitaxialoberflächenschicht eines zweiten Leitungstyps, der dem ersten Leitungstyp auf einer ersten Hauptfläche des genannten Substrats entgegengesetzt ist, einem an die Oberfläche grenzenden Kanalgebiet des genannten ersten Leitungstyps in der genannten Epitaxialschicht, das einen PN-Uebergang damit bildet, einem an die Oberfläche grenzenden Source-Gebiet des genannten zweiten Leitungstyps in dem genannten KanalGebiet, einem an die Oberfläche grenzenden Drain-Gebiet des genannten zweiten Leitungstyps in der genannten Epitaxialschicht, das von dem genannten Kanalgebiet getrennt ist, einer Isolierschicht auf der genannten Epitaxialschicht, die wenigstens denjenigen Teil des genannten Kanalgebietes bedeckt, der zwischen dem genannten Source-gebiet und dem genannten Drain-gebiet liegt, einer Gate-Elektrode auf der genannten Isolierschicht über den genannten Teil des Kanalgebietes und elektrisch von der genannten Epitaxialschicht isoliert, wobei die Source-und Drain-Elektrode mit dem Sourcebzw. Drain-Gebiet des genannten Transistors verbunden ist und mit einer Substrat-Elektrode auf einer zweiten Hauptfläche des genannten Substrats gegenüber der ersten Hauptfläche, dadurch gekennzeichnet, dass ein an die Oberfläche grenzendes Injektionsgebiet des genannten ersten Leitungstyps in der genannten Epitaxialoberflächenschicht des zweiten Leitungstyps vorgesehen ist und damit einen PN-Uebergang bildet, wobei das genannte Injektionsgebiet zwischem dem genannten Kanalgebiet und dem genannten Drain-Gebiet liegt und zwar näher bei dem genannten Kanalgebiet also bei dem genannten und dass eine Injektionselektrode mit dem genannten Injektionsgebiet derart elektrisch verbunden ist, dass dem genannten Injektionsgebiet eine aüssere Spannung unmittelbar zugeführt werden kann.

2. Lateraler DMOS-Transistor nach Anspruch 1, dadurch gekennzeichnet, dass die Dotierungskonzentration N und die Dicke d der genannten Epitaxialoberflächenschicht entsprechend der REduced SURface Field (RESURF)-Technik gewählt worden sind, so dass $N \times d$ etwa $10^{12}$ Atome/cm² beträgt.

3. Lateraler DMOS-Transistor nach Anspruch 1, dadurch gekennzeichnet, dass das genannte an die Oberfläche grenzende Injektionsgebiet neben aber nicht in Kontakt mit dem Kanalgebiet liegt.

4. Lateraler DMOS-Transistor nach Anspruch 1, dadurch gekennzeichnet, dass das genannte Injektionsgebiet eine Dicke hat von etwa einem Mikrometer und einen Oberflächendotierungspegel von etwa $10^{19}$ Atomen/cm³.

**Revendications**

1. Transistor DMOS latéral muni d'un substrat semiconducteur d'un premier type de conductivité, d'une couche superficielle épitaxiale d'un second type de conductivité, opposé au premier type de conductivité, située sur une première surface principale dudit substrat, d'une région de canal dudit premier type de conductivité contiguë à la surface et située dans ladite couche épitaxiale tout en formant une jonction pn avec celle-ci, d'une région de source dudit second type de conductivité contiguë à la surface et située dans ladite région de canal, d'une région de drain dudit second type de conductivité contiguë à la surface et située dans ladite couche épitaxiale tout en étant séparée de ladite région de canal, d'une couche isolante située sur ladite couche épitaxiale et recouvrant au moins la partie de ladite région de canal située entre lesdites régions de source et de drain, d'une électrode de grille située sur ladite couche isolante, au-dessus de ladite partie de la région de canal, et électriquement isolée de ladite couche épitaxiale, d'électrodes de source et de drain reliées respectivement aux régions de source et de drain dudit transistor, et d'une électrode de substrat située sur une seconde surface principale dudit substrat, opposée à la première surface principale, caractérisé en ce qu'une région d'injection dudit premier type de conductivité contiguë à la surface est prévue dans ladite couche superficielle épitaxiale du second type de conductivité et forme une jonction pn avec celle-ci, ladite région d'injection étant située entre ladite région de canal et ladite région de drain tout en étant plus proche de ladite région de canal que de ladite région de drain, et en ce qu'une électrode d'injection est reliée électriquement à ladite région d'injection, de sorte qu'une tension externe peut être appliquée directement à ladite région d'injection.

2. Transistor DMOS latéral selon la revendication 1 caractérisé en ce que la concentration de dopage N et l'épaisseur d de ladite couche superficielle épitaxiale sont choisies selon la technique dite de REduced SURface Field (RESURF) de façon qu'approximativement $N \times d = 10^{12}$ atomes/cm².

3. Transistor DMOS latéral selon la revendication 1 caractérisé en ce que ladite région d'injection contiguë à la surface est située à côté de ladite région de canal sans être en contact avec celle-ci.

4. Transistor DMOS latéral selon la revendication 1 caractérisé en ce que ladite région d'injection a une épaisseur de l'ordre du micromètre et un niveau de dopage en surface de l'ordre de $10^{19}$ atomes/cm³.

0 115 098